**Europäisches Patentamt**

**European Patent Office**

**Office européen des brevets**

(11) Veröffentlichungsnummer : **0 056 949**
**B1**

# EUROPÄISCHE PATENTSCHRIFT

(45) Veröffentlichungstag der Patentschrift :
**13.06.84**

(21) Anmeldenummer : **82100179.9**

(22) Anmeldetag : **13.01.82**

(51) Int. Cl.³ : **H 04 Q 3/52**, **H 04 N 7/10**,
**H 04 N 5/22**

(54) **Koppelfeld in Matrixform für Signalfrequenzen im Megahertzbereich.**

(30) Priorität : **22.01.81 DE 3101932**

(43) Veröffentlichungstag der Anmeldung :
**04.08.82 Patentblatt 82/31**

(45) Bekanntmachung des Hinweises auf die Patenterteilung : **13.06.84 Patentblatt 84/24**

(84) Benannte Vertragsstaaten :
**AT BE CH DE FR GB IT LI NL SE**

(56) Entgegenhaltungen :
**DE-A- 2 339 757**
**US-A- 3 789 151**
**NACHRICHTENTECHNISCHE ZEITSCHRIFT, Band 33,**
**No. 9 September 1980 BERLIN (DE) B. RALL:**
**« Bildfernsprechkoppelfeld mit integrierten**
**Halbleiterkoppelpunkten », Seiten 602/607**

(73) Patentinhaber : **Licentia Patent-Verwaltungs-GmbH**
**Theodor-Stern-Kai 1**
**D-6000 Frankfurt/Main 70 (DE)**

(72) Erfinder : **Burkhart, Johann, Dipl.-Phys.**
**Gärtnerstrasse 14**
**D-7913 Senden (DE)**
Erfinder : **Rall, Bernhard, Dipl.-Ing.**
**Albecker Steige 67**
**D-7900 Ulm (DE)**
Erfinder : **Schlüter, Klaus, Dipl.-Ing.**
**Schleienweg 8**
**D-7900 Ulm-Gögglingen (DE)**

(74) Vertreter : **Schickle, Gerhard, Dipl.-Ing. et al**
**Licentia Patent-Verwaltungs-GmbH Theo-**
**dor-Stern-Kai 1**
**D-6000 Frankfurt/Main 70 (DE)**

**Beschreibung**

Ein Breitbandkoppelfeld mit den Merkmalen des Oberbegriffs des Anspruches 1 ist bekannt (Nachrichten der Telefonbau & Normalzeit (1980) Heft 82 «TN-Fernsprechsystem 6030 Zeitmultiplex mit farbtüchtigem elektronischen Video-Koppelfeld» von Bruno Beuss, Peter Loewenhoff, Bernhard Rall, Rudolf Saumweber). Das bekannte Koppelfeld verbindet vierzig Bildfernsprechteilnehmer über Halbleiterkoppelpunkte miteinander. Dafür ist ein Dreieckskoppler gewählt, der für jede Verbindung einen Koppelpunkt enthält, in welchem aber zwei Schaltpunkte vorgesehen sind, nämlich jeweils einer für eine der beiden Übertragungsrichtungen der zwischen zwei Teilnehmern zu übertragenden Bildfernsprechsignale. Die Verbindung der Teilnehmer über den Koppelpunkt erfolgt dabei erdunsymmetrisch. Dabei werden monolithisch integrierte Koppelbausteine mit fünf mal zwei Koppelpunkten, bestehend aus je zwei Schaltern verwendet. Zur besseren Entkopplung ist dieser Halbleiterbaustein in ein vierzigpoliges Keramikgehäuse mit allseitigem Kupferschirm eingebaut. Aus den gleichen Gründen sind ferner alle bildsignalführenden Leitungen von Schirm- oder Steuerleitungen umgeben. Alle diese Leitungen befinden sich in einer Multilayer-Leiterplatte.

Dieses beschriebene Breitbandkoppelfeld wird mit Frequenzen bis zu 10 Megahertz betrieben.

Ein Bedürfnis für ein Koppelfeld für noch höhere Frequenzen besteht aufgrund der Frequenzverknappung für Kabelfernsehanlagen, bei denen beispielsweise 30 Fernsehprogramme so auf einzelne Teilnehmer verteilt werden müssen, daß jeder Teilnehmer eine Reihe von diesen Programmen empfangen kann, wobei u. U. dafür gesorgt sein muß, daß unterschiedliche Teilnehmer unterschiedliche Kombinationen von Programmen zugeleitet bekommen. Die Verteilung erfolgt dabei bevorzugt in demjenigen trägerfrequenten Bereich, für den Fernsehempfänger für Rundfunkempfang eingerichtet sind (Wissenschaftliche Berichte AEG-Telefunken 53 (1980) 1-2, Seiten 62 bis 71).

Für solche und andere Anwendungsfälle bei Frequenzen, die wesentlich über der Videolage von Fernsehsignalen liegen, ist es Aufgabe der Erfindung, ein Koppelfeld zu schaffen, bei dem eine ausreichende Entkopplung zwischen Signalleitungen gewährleistet ist, die nicht gerade über einen Koppelpunkt miteinander verbunden sind.

Diese Aufgabe wird gelöst durch die kombinierten Merkmale des Anspruches 1. Vorteilhafte Weiterbildungen sind in den Unteransprüchen angegeben.

Vereinfacht ausgedrückt wird mit der Erfindung folgendes vorgeschlagen :

Ausgangspunkt ist ein Koppelfeld mit integrierten Koppelbausteinen jeweils für mehrere Koppelpunkte und einer Multilayer-Leiterplatte mit zeilen- und spaltenweise in unterschiedlichen Ebenen angeordneten Signalleitungen, die dort von Steuer- und/oder Schirmleitungen begleitet sind, wobei die Ebenen jeweils zwischen metallischen Schirmebenen liegen.

Ein solches Koppelfeld soll für oberhalb des Videobereiches liegende breitbandige Frequenzbereiche geeignet gemacht werden, bei weitgehender Vermeidung von Verkopplungen über Erdpotential und Betriebsspannungen.

Dazu sind die Signalleitungen als erdsymmetrische und mit ihrem Wellenwiderstand abgeschlossene Streifenleiterpaare ausgebildet, die jeweils zwischen hochfrequenzmäßig geerdeten Leiter liegen, die als Steuer- oder Stromversorgungsleitungen dienen. Zusätzlich sind die Signalleiterpaare verdrillt und als Koppelpunkte sind schaltbare, erdsymmetrische, hochohmige Verstärker vorgesehen mit Kompensationselementen zur Kompensation der Restüberkopplung bei gesperrtem Koppelpunkt. Auch in den Koppelbausteinen sind die Signalleitungen zum Chip geschirmt.

Solche Koppelfelder können bevorzugt zur Verteilung trägerfrequenter Fernsehprogramme verwendet werden.

Die vorteilhafte Gesamtwirkung der Erfindung ergibt sich aus dem Konzept mit erdsymmetrischer Durchschaltung, woraus sich im einzelnen die Vorzüge ergeben :

Geringere galvanische Verkopplungen über Erdpotential und Betriebsspannungen, Kopplungsausgleich für kapazitive und induktive Kopplungen der Leitungen, geringe Verkopplungen über das Halbleitersubstrat.

Als zusätzlicher Vorteil ergibt sich, daß steckbare Koppelbausteine einsetzbar sind. Durch die Verwendung geschalteter Verstärker in den Koppelpunkten läßt sich die kapazitive Belastung der Signalleitungen relativ gering halten. Die Rauscheigenschaften können dabei verbessert werden, wenn Transistoren mit niedrigem Basiswiderstand und kleiner Kapazität verwendet werden. Eine kleine Kapazität erlaubt kleine Ströme und damit geringes Schrotrauschen.

Anhand der Zeichnungen wird ein bevorzugtes Ausführungsbeispiel der Erfindung näher erläutert. Es zeigen :

Figur 1   einen vergrößerten Querschnitt durch eine Multilayer-Leiterplatte mit prinzipieller Leiteranordnung,

Figur 2   ein Hochfrequenz-Leitungs-Ersatzschaltbild für eine Signalleitung (Signalleiterpaar),

Figur 3   das Layout der signalführenden Leiterebenen einer Multilayer-Leiterplatte,

Figur 4   ein Schaltbild für einen Koppelpunkt auf dem Chip eines Koppelbausteins,

Figur 5   einen vergrößerten Querschnitt durch die Mitte eines Koppelbausteins und die Mitte einer Steckverbindung,

Figur 6   eine Draufsicht auf einen Stecksockel eines Koppelbausteins mit Detailschnitt C-D,

Figur 7 den prinzipiellen äußeren Anschluß eines Koppelbausteins,

Figur 8 ein Verteilkoppelfeld mit mehreren Multilayer-Leiterplatten.

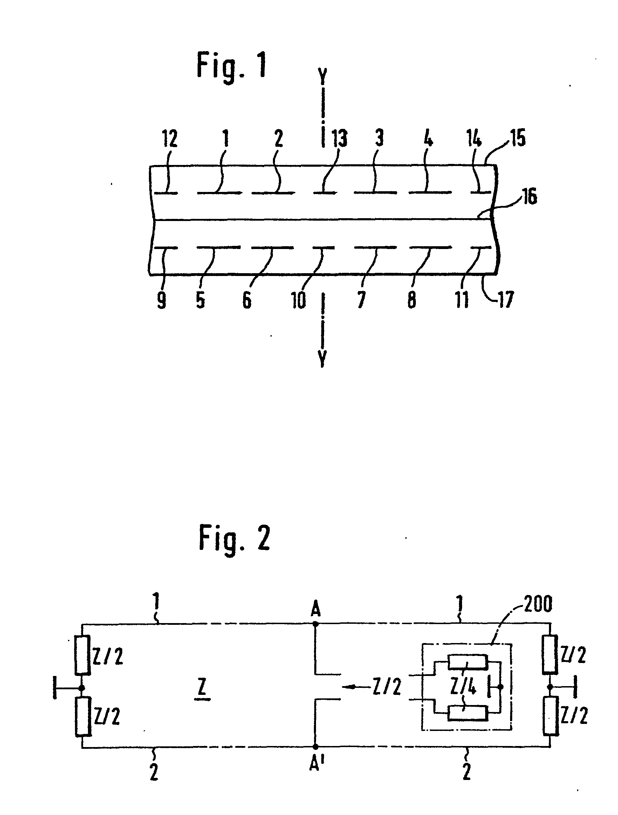

Fig. 1 zeigt einen vergrößerten Querschnitt durch eine Multilayer-Leiterplatte mit Signalleiter 1 bis 4 und Schirmleiter 12 bis 14, die sandwichartig in einer Ebene zwischen Schirmebenen 15 und 16 angeordnet sind, sowie Signalleiter 5 bis 8 und Schirmleiter 9 bis 11, die sandwichartig in einer weiteren Ebene, die zwischen Schirmebenen 16 und 17 liegt, angeordnet sind. Um die Anordnung der Leiter zu verdeutlichen, ist in Fig. 1 die Schicht zwischen den Ebenen 16 und 17 um eine zu den Ebenen senkrecht verlaufende Achse y-y um 90° gedreht dargestellt.

Die Signalleiter 1, 2 ; 3, 4 ; 5, 6 und 7, 8 sind jeweils Signalleiterpaare einer Signalleitung, wobei die Signalleiterpaare 1, 2 und 3, 4 paarweise zwischen den Schirmleitern 12 bis 14 verlaufen und beispielsweise die Zeilensignalleitungen einer Koppelpunktmatrix sein können.

Die Signalleiterpaare 5, 6 und 7, 8 verlaufen, wie die gedrehte Darstellung erkennen läßt, ebenfalls jeweils paarweise zwischen den Schirmleitern 9 bis 11 und können beispielsweise die Spaltensignalleitungen einer Koppelpunktmatrix sein. Die Leiter 5 bis 11 verlaufen senkrecht zu den Leitern 1 bis 4 und 12 bis 14 (aus Fig. 1 wegen der Drehung nicht erkennbar).

Die Schirmleiter 9 bis 14 können durch für Hochfrequenz geerdete Signalleitungen oder Stromversorgungsleitungen gebildet sein. Die Signalleiterpaare 1, 2 ; 3, 4 ; 5, 6 ; ... bilden Streifenleiterpaare.

In Fig. 2 ist das HF-Leitungs-Ersatzschaltbild z. B. des Signalleiterpaares 1, 2 dargestellt. Das Signalleiterpaar hat den Wellenwiderstand Z und ist am Ende durch die Reihenschaltung zweier Widerstände, jeweils mit dem Widerstandswert Z/2 abgeschlossen, die in der Mitte für Hochfrequenz an Erdpotential liegen. Im Verlauf der Signalleitungen befinden sich mehrere Abzweige, von denen einer angedeutet ist. Er ist mit A, A' bezeichnet. Der Eingangswiderstand an einem solchen Abzweig beträgt Z/2. In dem mit unterbrochenen Linien gezeichneten Kasten 200 ist dafür das Ersatzschaltbild angegeben, das aus der Reihenschaltung zweier am Verbindungspunkt für Hochfrequenz (HF) auf Erdpotential liegenden Widerständen mit dem jeweiligen Widerstandswert Z/4 besteht.

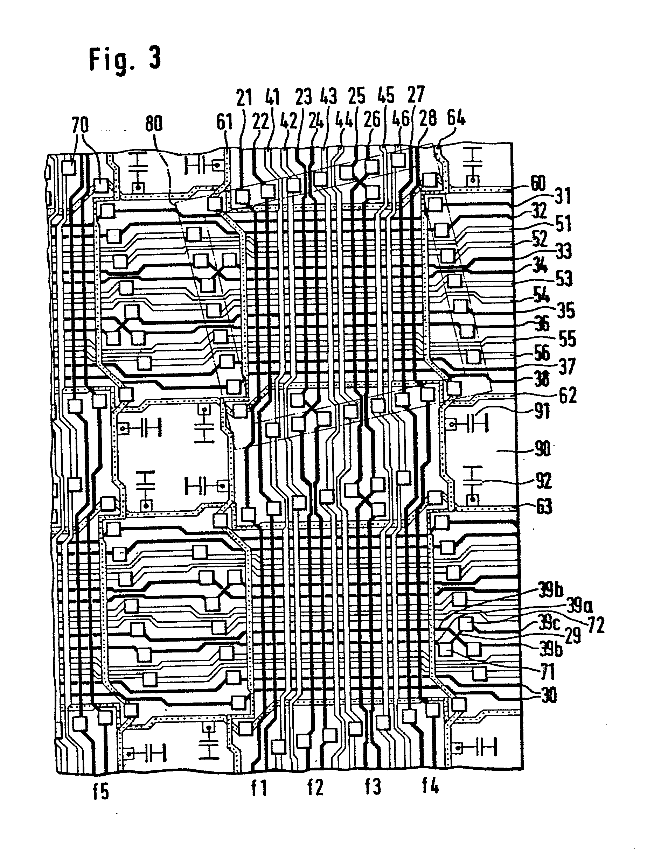

Fig. 3 zeigt das Layout der signalführenden Leiterebenen einer Multilayer-Leiterplatte. In dieser Figur sind Spaltensignalleiter 21 bis 28 schwarz hervorgehoben, ebenso Zeilensignalleiter 31 bis 38. Jeweils zwischen zwei Spalten- bzw. Zeilensignalleiter liegen, jeweils in der gleichen Ebene, Steuersignalleiter 41 bis 46 bzw. 51 bis 56.

Die durch die Spaltensignalleiter 21 bis 28 mit den Steuersignalleitern 41 bis 46 einerseits und die Zeilensignalleiter 31 bis 38 mit den Steuersignalleitern 51 bis 56 andererseits gebildeten Bündel sind in ihrer jeweiligen Ebene von am Rande liegenden Stromversorgungsleitern 60 bis 64 umgeben, die in der jeweils zugehörigen Ebene liegen und gegenüber den anderen Leitern durch Punktierung zeichnerisch hervorgehoben sind.

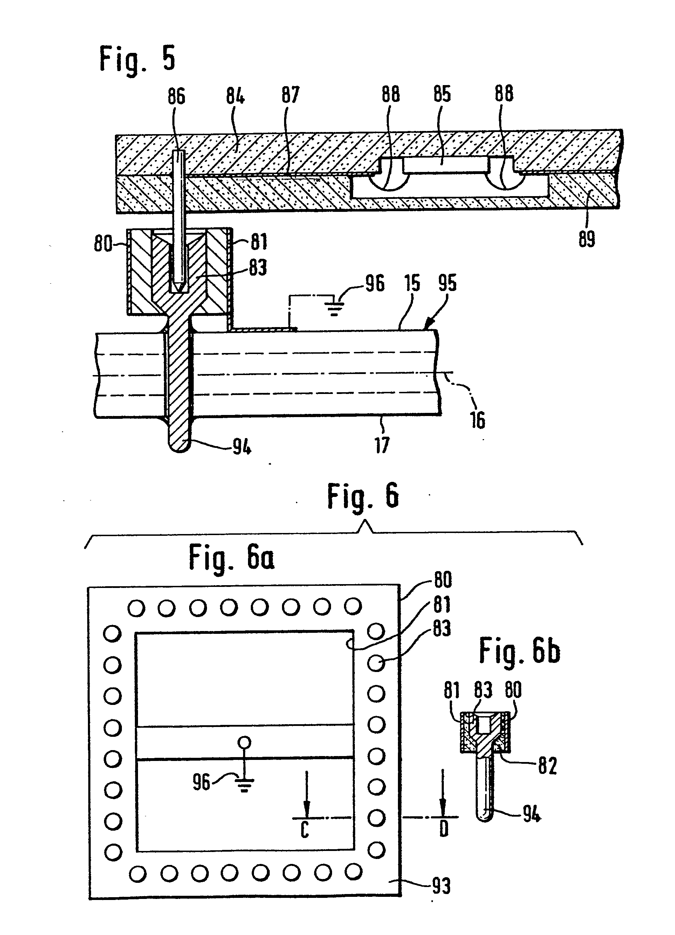

Die Kreuzungsbereiche der Bündel, die jeweils vier Zeilen- bzw. Spaltensignalleitungen (Spaltensignalleiterpaare) enthalten, sind untereinander gleich gestaltet. Über ihnen ist jeweils ein Koppelbaustein anzuordnen für vier mal vier Koppelpunkte, wobei die elektrischen Verbindungen über durch Quadrate angedeutete Steckverbindungen 70 hergestellt werden können. Solche Steckverbindungen 70 bilden ein Quadrat für ein quadratisches Koppelbausteingehäuse, bei dem die Elemente für die Steckverbindungen zwischen zwei metallisierten Seitenwänden 80, 81 eines umlaufenden Kanales angeordnet sind (vergl. Fig. 5 und 6).

Um die Signalleiterpaare der Signalleitungen mit unterschiedlichen Schlaglängen verdrillen zu können, ist an den dazu erforderlichen Kreuzungsstellen ein Umweg eines Leiters über die andere Leiterebene erforderlich, beispielsweise muß der Zeilensignalleiter 39a (Fig. 3, unten rechts) um den Zeilensignalleiter 39b dadurch herumgeführt werden, daß er über eine Durchkontaktierung 71 auf einen Umweg 29 in der Ebene der Spaltensignalleiter geführt wird. Von dort gelangt er über eine Steckverbindung 72 wieder in die Ebene der Zeilensignalleitungen als Zeilensignalleiter 39c.

An leiterfreien Stellen 90 zwischen jeweils vier Überkreuzungsbereichen von vier Leiterbündeln befinden sich Abblockkondensatoren 91, 92, die mit den Stromversorgungsleitern 64, 63, 62 usw. einerseits und andererseits mit Erdpotential verbunden sind, zur hochfrequenzmäßigen Entkopplung direkt an den Koppelbausteinen, zu deren Stromversorgung die Stromversorgungsleitungen vorgesehen sind.

Wenn beispielsweise die Spaltensignalleitungen Fernsehprogrammsignale führen mit unterschiedlichen Trägerfrequenzen f1, f2, f3, f4, dann kann auf einer mit einem Ausgang verbundenen Zeilensignalleitung 30 (Fig. 3, unten rechts) durch entsprechendes Durchschalten von an diesen Zeilensignalleitungen liegenden Koppelpunkten dafür gesorgt werden, daß ein, zwei, drei oder vier Fernsehprogramme zu diesem Ausgang und damit zu einem Fernsehteilnehmer gelangen. Der Fernsehteilnehmer kann dann mit seinem Programmwähler am Empfänger eines der vier Programme auswählen. In einem benachbarten Bündel von Spaltensignalleitungen können weitere Programme mit Trägerfrequenzen f5 usw. geführt werden. Auch hiervon können Programme auf die Zeilensignalleitung 30 geschaltet werden.

In vorteilhafter Weise sind, wie Fig. 3 erkennen läßt, die Kanten der Koppelbaustein-Gehäuse in einem Winkel von ungefähr 12° zur Richtung der Leiterbündel angeordnet. Dies hat sich deshalb als zweckmäßig erwiesen, weil es dann leichter ist, die Leiter zwischen den Steckverbindungen 70 hindurchzuführen, ohne in der Verdrahtung einen Zickzackweg vorzusehen, der unnötig Platz beanspruchen würde.

In einem Koppelbaustein-Gehäuse sind mehrere Koppelpunkte auf einem Halbleiterchip angeordnet. Innerhalb des Gehäuses führen, zwischen metallischen Schirmen angeordnete Zuleitungen von den Steckverbindungen am Rande des Koppelbausteines zum Halbleiterchip.

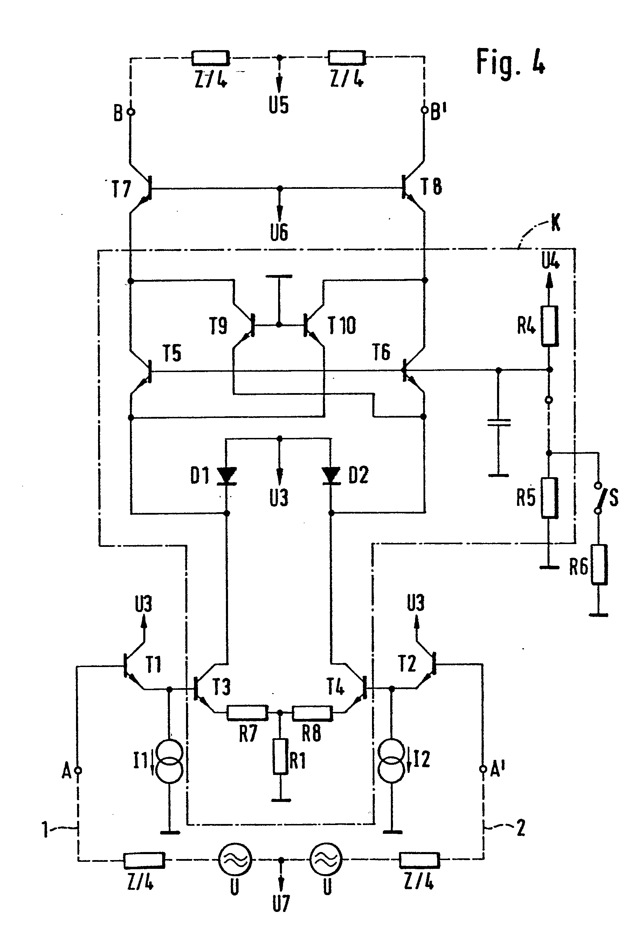

Fig. 4 zeigt ein vereinfachtes Schaltbild eines Koppelpunktes eines Koppelbausteins. Der eigentliche Koppelpunkt K liegt innerhalb der gestrichelten Linie. In einem Koppelbaustein befinden sich 4 × 4 = 16 Koppelpunkte und außerdem jeweils vier Eingangsschaltungen und vier Ausgangsschaltungen.

Eine zu einem Koppelpunkt K gehörende Eingangs- und Ausgangsschaltung ist in Fig. 4 ebenfalls dargestellt (T1, T2 bzw. T7, T8). Die von einem Koppelpunkt zu schaltenden Signale kommen aus einer Spaltensignalleitung von einem Abzweig A, A' und zwar gemäß dem Ersatzschaltbild gemäß Fig. 2 (Einheit 200) von erdsymmetrisch angeordneten Signalspannungsquellen U über je einen Innenwiderstand Z/4. Wenn der Wellenwiderstand einer Spaltensignalleitung beispielsweise Z = 40 Ohm beträgt, dann ist Z/4 = 10 Ohm.

In Fig. 4 sind diese Signalspannungsquellen U mit Innenwiderstand Z/4, Signalleiter 1 und 2 mit Abzweig A, A', strichliert dargestellt. Von den Abzweigpunkten A, A' ausgehend werden Transistoren T1, T2 gesteuert, für die Gleichspannungsquellen U7, U3 und Gleichstromquellen I1, I2 vorgesehen sind. Diese Transistoren T1, T2 dienen als Eingangsschaltung, deren Eingangswiderstand gegenüber dem Widerstand Z groß ist, insbesondere mehr als hundert mal größer.

Von dieser Eingangsschaltung werden zunächst Transistoren T3, T4 mit gemeinsamem Emitterwiderstand R1 gesteuert, für die eine Spannungsquelle U3, die die Gleiche wie die der Transistoren T1 und T2 sein kann, als Spannungsversorgung über Dioden D1, D2, vorgesehen ist. Von den Transistoren T3, T4 übertragene Signale können durchgeschaltet werden über schaltbare, erdsymmetrische Verstärker in Gestalt von Transistoren T5, T6, die als Schalter dienen. Zu ihrer gemeinsamen Steuerung ist zunächst, an einer Gleichspannungsquelle U4 liegend, ein Widerstand R4 vorgesehen (Bild 4, oben rechts), der mit einer Steuerschaltung, die nicht Teil des Koppelpunktes auf dem Chip ist, einem Spannungsteiler bildet, enthaltend den Widerstand R5 bzw., wenn der Schaltkontakt S geschlossen ist, den Widerstand R6. Dann ist durch den als Ersatz für einen übersteuerten Transistor eingezeichneten Widerstand R6 von nur 100 Ohm das Basispotential an den Transistoren T5, T6 soweit herabgesetzt, daß diesegesperrt sind, während sie bei geöffnetem Schaltkontakt S durchgeschaltet sind. In diesem durchgeschalteten Zustand ist eine Verbindung hergestellt zwischen den Abzweigpunkten A, A' einerseits und Ausgangspunkten B, B' zu einer Zeilensignalleitung andererseits, die durch Reihenersatzwiderstände Z/4 versinnbildlicht ist. Über die Zeilensignalleitung wird von einer Gleichspannungsquelle U5 die Versorgungsspannung geliefert für eine aus Transistoren T7, T8 bestehende Ausgangsschaltung, die wiederum hochohmig ist gegenüber der Zeilensignalleitung.

Die Basen der Transistoren T7, T8 erhalten eine Vorspannung von einer Gleichspannungsquelle U6. In ähnlicher Weise wird von einer Vorspannungsquelle U7 über die Spaltensignalleitung und die Abzweigpunkte A, A' eine Basisvorspannung für die Transistoren T1, T2 geliefert.

Die Hochohmigkeit der Ausgangsschaltung T7, T8 ist besonders wichtig, weil an der Zeilensignalleitung ja mehrere durchgeschaltete Koppelpunkte liegen können, welche die Zeilensignalleitung, also die Signalleitung mit den abgehenden Signalen, gemeinsam belasten und den Wellenwiderstand der Zeilensignalleitung diskontinuierlich verändern.

Wenn die als Schalter dienenden Transistoren T5, T6 gesperrt sind, besteht dennoch die Gefahr, daß ein schwaches Signal vom Abzweigpunkt A zum Abzweigpunkt B bzw. vom Abzweigpunkt A' zum Abzweigpunkt B' gelangt. Zur Kompensation dieser schwachen Signale sind den Transistoren T5 und T6 geometrisch genau gleiche Transistoren T9 und T10 zugeordnet, die ständig gesperrt sind, aber dabei dennoch einerseits schwache Signale vom Emitter des Transistors T6 zum Kollektor des Transistors T5 und andererseits vom Emitter des Transistors T5 zum Kollektor des Transistors T6 koppeln. Diese schwachen Signale befinden sich aber in Gegenphase zu den über die Transistoren T5, T6 zum Ausgang hinübergekoppelten Signalen und wirken daher kompensierend bezüglich der sogenannten Restüberkopplung über die gesperrten Transistoren T5, T6.

Durch Widerstände R7 und R8 in den Emitterzuleitungen der Transistoren T3 bzw. T4 kann auf Kosten der Verstärkung des Koppelfeldes die Linearität des Koppelfeldes soweit erhöht werden, daß die hohen Forderungen bezüglich der Freiheit von Klirren dritten Grades erfüllt werden, d. h., daß ein Intermodulationsabstand von über 69 dB im Bereich von 5 bis 17 mV am Eingang A, A' bei einer Spannungsverstärkung von 0,3 erreicht werden kann. Die untere Grenze von 5 mV am Eingang A, A' ist durch die Forderung nach einem Signal-Rauschabstand von mehr als 55 dB gegeben. Der Gleichstrom durch den gemeinsamen Emitterwiderstand R1 der Transistoren T3 und T4 beträgt etwa 3 bis 4 mA.

Fig. 5 zeigt einen vergrößerten Querschnitt mitten durch einen Koppelbaustein und eine Steckverbindung. In einer Mulde einer Keramikplatte 84 befindet sich ein Halbleiterchip 85 mit Schaltungen nach Fig. 4. Zu diesem Chip führen, von Stiften 86 aus, Leiterbahnen 87 auf einer der Seiten des Keramikkörpers zum Chip 85, wobei Bondrähte 88 letztlich die Verbindung herstellen zwischen den Leiterbahnen 87 und dem Chip 85. Schließlich ist die Mulde mit dem Chip 85 durch einen Deckel 89 zugedeckt. Die Außenflächen der Keramikplatte 84 und des Deckels 89, die zusammen ein Gehäuse bilden, sind in unmittelbarer Nähe der Stifte 86 zur Schirmung metallisiert, wobei die Metallisierung und der Chipboden, also die Muldenfläche, an die (negative) Masseleitung über einen oder mehrere Stife angeschlossen sind.

In Fig. 6 ist eine Draufsicht auf einen zugehörigen Stecksockel eines Koppelbausteins mit Detailschnitt durch die Stelle C-D dargestellt. Das Gehäuse ist quadratisch und weist an jeder der vier Seiten acht Stifte in einem Sockelraster auf. Als Sockel ist ein Stecksockel 93 vorgesehen, der eine rahmenförmige Gestalt hat. Von einem Element 83 (Steckbuchse) einer Steckverbindung ist in Teilfigur b ein Querschnitt C-D dargestellt. Die Steckbuchse 83 hat einen stiftförmigen Teil 94 zum Einstecken in und Verlöten mit einer der in Fig. 3 gezeigten Steckverbindungen beispielsweise 70 (Fig. 3, oben links) der Multilayer-Leiterplatte, die in Fig. 5 mit 95 bezeichnet ist. Die Steckbuchse 83 ist zwischen metallisierten Wänden 80, 81 angeordnet, die als Schirm für die Steckverbindungen dienen und mit Massepotential 96 verbunden sind.

Der Stecksockel nach Fig. 6a kann auch durch vier Streifen (single-in-line socket) zu je acht Steckbuchsen 83 realisiert werden, wobei jeder Streifen für sich abgeschirmt ist. Jeder dieser Streifen kann beispielsweise eine mit der Abschirmung verbundene Lötfahne aufweisen, die an eine Masseleitung der Multilayer-Leiterplatte anzulöten ist.

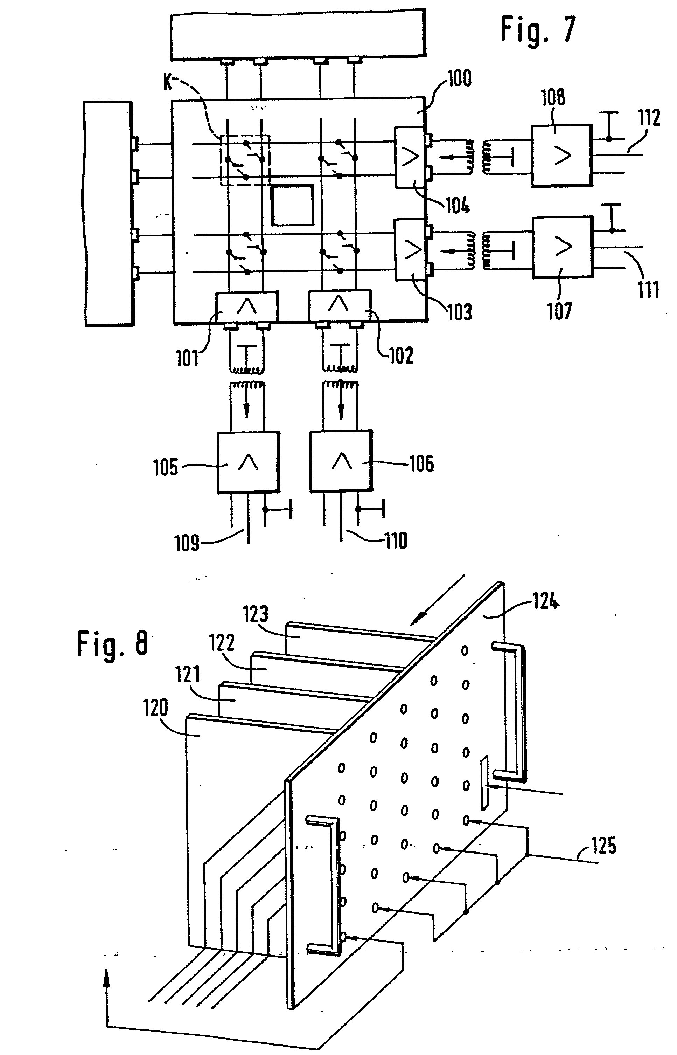

Fig. 7 zeigt zur Verdeutlichung anhand eines vereinfachten Koppelbausteines dessen Anschluß an einer Ecke eines Koppelfeldes. Der vereinfachte Koppelbaustein enthält hier nur zwei mal zwei Koppelpunkte, wobei jeweils zwei Koppelpunkte einer gemeinsamen Eingangsschaltung 101, 102 (entsprechend T1, T2 in Fig. 4) bzw. Ausgangsschaltung 103, 104 (entsprechend T7, T8 in Fig. 4) zugeordnet sind. Die Koppelpunkte K selbst sind jeweils durch zwei kleine Schaltkontakte angedeutet. Die Figur zeigt vor allem, wie dem Koppelfed an den Eingängen und Ausgängen jeweils Eingangsverstärker 105, 106 und Ausgangsverstärker 107, 108 zugeordnet sind, mit deren Hilfe ein Übergang von erdunsymmetrischen Eingangsleitungen 109, 110 bzw. Ausgangsleitungen 111, 112 vorgenommen wird auf die erdsymmetrischen Leitungen innerhalb des Koppelbausteins 100. Zum Übergang zwischen den Eingangs- bzw. Ausgangsverstärkern und dem Koppelbaustein dienen dabei Transformatoren T.

In Fig. 8 ist ein Verteilerkoppelfeld dargestellt mit mehreren untereinander gleichen Koppelfeldern 120 bis 123 mit jeweils zweiunddreißig mal zweiunddreißig Ein- bzw. Ausgängen. Die Koppelfeldplatinen stehen zur besseren Belüftung senkrecht und haben eine gemeinsame Ausgangsleiterplatte 124, an der die Ausgangsbuchsen 125 nur schematisch dargestellt sind, deren Anzahl sich ergibt aus dem Produkt der Anzahl der Koppelfelder 120 bis 123, und der Anzahl (Zweiunddreißig) der Ausgänge je Koppelfeld. Mit einem solchen Verteilerkoppelfeld können also beispielsweise zweiunddreißig auf die vorhandenen zweiunddreißig Eingänge gegebene Fernsehprogramme an eine große Anzahl von Verbrauchern verteilt werden.

## Ansprüche

1. Koppelfeld in Matrixform für Signalfrequenzen im Megahertzbereich mit folgenden Merkmalen :

a) es enthält jeweils auf einem Chip integrierte Koppelbausteine, die jeweils für mehrere Koppelpunkte vorgesehen und jeweils in einem geschirmten Gehäuse (84, 89) angeordnet sind und je Koppelpunkt zwei Halbleiterschalter aufweisen,

b) die Koppelbausteine sind über den Kreuzungsbereichen der zugehörigen Zeilen- (31 bis 38) und Spaltenleitungen (21 bis 28) auf einer Multilayer-Leiterplatte untergrebracht, welche zeilen- und spaltenweise in unterschiedlichen Leiterebenen Signalleitungen, nämlich Zeilen- und Spaltensignalleitungen, aufweist, die von Steuer- und/oder Schirmleitern umgeben sind und die jeweils zwischen metallischen Schirmebenen (15, 16, 17) liegen, gekennzeichnet durch folgende Merkmale :

c) die Signalleitungen (1, 2 in Fig. 2 ; 21 bis 28, 31 bis 38 in Fig. 3) sind erdsymmetrisch als Streifenleiterpaare ausgeführt und an ihren beiden Enden mit ihrem Wellenwiderstand (Z in Fig. 2) abgeschlossen, wobei innerhalb einer Leiterebene jeweils zwischen zwei Signalleiterpaaren (31, 32 und 33, 34) zwei hochfrequenzmäßig geerdete Steuer- oder Stromversorgungsleiter (51, 52) liegen,

d) die Signalleiter (39a, 39b) jeweils eines Signalleiterpaares sind in ihrer Leiterebene mit unterschiedlichen Schlaglängen (lenght of twist) verdrillt, wobei an dazu erforderlichen Überkreuzungsstellen ein Umweg (29) eines Leiters über eine andere Leiterebene vorgesehen ist (Fig. 3),

e) jeweils eine Anzahl von Zeilen- (31 bis 38) und Spaltensignalleitungen (21 bis 28), die angepaßt ist an die je Koppelbaustein vorgesehene Anzahl von Koppelpunkten, ist Teil eines Leiterbündels, dessen Randleiter (60 bis 64) jeweils für die Koppelbausteine Stromversorgungsleiter bilden, für welche an leiterfreien Flächen (90) der Leiterplatte zwischen jeweils vier Koppelbausteinen Abblockkondensatoren (91, 92) vorgesehen sind (Fig. 3),

f) in einem Koppelbaustein ist je Koppelpunkt ein schaltbarer, erdsymmetrischer Verstärker (T5, T6) als Schalter zwischen einer Zeilen- und einer Spaltensignalleitung vorgesehen mit einer vorgeschalteten Eingangsschaltung (T1, T2), die gegenüber dem Wellenwiderstand (Z) der Signalleitung (1, 2) mit ankommenden Signalen einen hochohmigen Eingangswiderstand hat, und mit einer nachgeschalteten Ausgangsschaltung (T7, T8) mit einem Ausgang (B, B'), der gegenüber der Signalleitung mit abgehenden Signalen hochohmig ist (Fig. 4),

g) der schaltbare Verstärker (T5, T6) enthält erdsymmetrisch zwei vom leitenden, im wesentlichen linearen Bereich in den Sperrbereich steuerbare, aktive Halbleiterbauelemente (T5, T6) (Durchschaltelemente) sowie vom gleichen Leitungstyp erdsymmetrisch zwei den Durchschaltelementen (T5, T6) geometrisch gleiche, dauernd gesperrte Halbleiterbauelemente (T9, T10) (Kompensationselemente), die einerseits jeweils mit ihrem Emitter mit dem Emitter jeweils eines der Durchschaltelemente (T5, T6) und andererseits jeweils mit ihrem Kollektor mit dem Kollektor des jeweils anderen der Durchschaltelemente (T6, T5) zur Kompensation der Restüberkopplung über die gesperrten Durchschaltelemente (T5, T6, Fig. 4) verbunden sind,

h) in Randnähe eines Koppelbausteins anbringbare Steckelemente (83, Fig. 6) für Steckanschlüsse (86, Fig. 5) und im Inneren des Koppelbausteines angeordnete Signalzuleitungen (87) zum Chip (85) sind zwischen Schirmen (u. a. 80, 81) angeordnet (Fig. 5).

2. Koppelfeld nach Anspruch 1, dadurch gekennzeichnet, daß für den Umweg (29) ein Steckanschluß (72) mitbenutzt ist (Fig. 3).

3. Koppelfeld nach Anspruch 1 oder 2, dadurch gekennzeichnet, daß das Gehäuse des Koppelbausteines (Fig. 5) im wesentlichen quadratisch ist und die Zeilen- und Spaltenrichtungen des Signalleitungen zu den Kanten der Gehäuse seitenflächen unter einem Winkel verlaufen (Fig. 3).

4. Koppelfeld nach einem der vorangehenden Ansprüche, dadurch gekennzeichnet, daß mehrere Koppelpunkte, die an einer Signalleitung (30) liegen, welche mit einem Koppelfeldausgang verbunden ist, durch eine Steuerschaltung gleichzeitig durchschaltbar sind.

5. Koppelfeld nach einem der vorangehenden Ansprüche, dadurch gekennzeichnet, daß unterschiedlichen Koppelfeldeingängen Signale mit unterschiedlichen Trägerfrequenzen (f1...f4) zugeführt sind, derart, daß in jeweils einen Koppelbaustein nur voneinander abweichende Trägerfrequenzen gelangen.

6. Koppelfeld nach einem der vorangehenden Ansprüche, dadurch gekennzeichnet, daß es Eingangs- (105, 106) und Ausgangsverstärker (107, 108) zur Wellenwiderstandsanpassung und Umsymmetrierung aufweist (Fig. 6).

7. Koppelfeld nach einem der vorangehenden Ansprüche, dadurch gekennzeichnet, daß ein Koppelbaustein vier mal vier Koppelpunkte aufweist (Fig. 3).

8. Koppelfeld nach einem der vorangehenden Ansprüche, dadurch gekennzeichnet, daß es Teil eines Verteilkoppelfeldes ist, in welchem mehrere untereinander gleiche Koppelfelder (120 bis 123 in Fig. 7) eingangsseitig zueinander parallel geschaltet sind, während die Ausgänge zu Buchsen auf einer gemeinsamen Ausgangsleiterplatte (124) geführt sind.

## Claims

1. Coupling field in matrix form for signal frequencies in the megahertz range with the following features :

a) it contains coupling blocks which are each integrated on a chip, each provided for several coupling points and each arranged in a respective screened housing (84, 89) and which each display two semiconductor switches for each coupling point, and

b) the coupling blocks are housed over the intersection regions of the associated row conductors (31 to 38) and column conductors (21 to 28) on a multilayer conductor plate which row by row and column by column in different conductor planes displays signal lines, namely row signal lines and column signal lines, which are surrounded by control conductors and/or screening conductors and each lie between metallic screening planes (15, 16, 17), characterised by the following features :

c) the signal lines (1, 2 in Fig. 2 ; 21 to 28, 31 to 38 in Fig. 3) are constructed as strip conductor pairs symmetrically to earth and terminated at both their ends by their characteristic impedance (Z in Fig. 2), wherein two control or current supply conductors (51, 52), which are earthed in terms of high frequency, each time lie between two signal conductor pairs (31, 32 and 33, 34) within one conductor plane,

d) the signal conductors (39a, 39b) of one signal conductor pair each time are twisted in their conductor plane with different lengths of twist, wherein a diversion (29) of one conductor over another conductor plane is provided at crossover places required for this (Fig. 3),

e) a number of row conductors (31 to 38) and column conductors (21 to 28), which number is matched to the number of coupling points provided for each coupling block, each time is part of a conductor bundle, the edge conductors (60 to 64) of which for each of the coupling blocks form respective current supply conductors, for which blocking capacitors (91, 92) between four coupling blocks each time are provided at conductor-free surfaces (90) of the conductor plate (Fig. 3),

f) a switchable amplifier (T5, T6), symmetrical to earth, is provided for each coupling point in one coupling block as switch between a row signal line and a column signal line with an input circuit (T1, T2), which is connected in front thereof and has a highly ohmic input impedance compared with the characteristic impedance (Z) of the signal line (1, 2) with incoming signals, and with an output circuit (T7, T8), which is connected therebehind and has an output (B, B'), which is highly ohmic compared with the signal line with outgoing signals (Fig. 4),

g) the switchable amplifier (T5, T6) contains symmetrically to earth two active semiconductor components (T5, T6) (connecting-through elements), which are controllable from the substantially linear conducting region into the blocking region, as well as two permanently blocked semiconductor components (T9, T10) (compensating elements), which are of the same conductor type as and geometrically similar to the connecting-through elements (T5, T6) an which are each connected on the one hand by their emitter with the emitter of a respective one of the connecting-through elements (T5, T6) and on the other hand by their collector with the collector of the respective other one of the connecting-through elements (T5, T6) for the compensation of the residual cross-coupling by way of the blocked connecting-through elements (T5, T6, Fig. 4), and

h) plug elements (83, Fig. 6), mountable near to the edge of a coupling block, for plug connections (86, Fig. 5) and signal feed lines (87), arranged in the interior of the coupling block, to the chip (85) are arranged between screens (inter alia 80, 81) (Fig. 5).

2. Coupling field according to claim 1, characterised thereby, that a plug connection (72) is also used for the diversion (29) (Fig. 3).

3. Coupling field according to claim 1 or 2, characterised thereby, that the housing of the coupling block (Fig. 5) is substantially square and the row and column directions of the signal lines run at an angle to the edges of the side surfaces of the housing (Fig. 3).

4. Coupling field according to one of the preceding claims, characterised thereby, that several coupling points, which lie at one signal line (30) connected with one coupling field output, are connectable through simultaneously by one control circuit.

5. Coupling field according to one of the preceding claims, characterised thereby, that signals of different carrier frequencies (f1 ... f4) are fed to different coupling field inputs in such a manner that only carrier frequencies differing one from the other get into each coupling block.

6. Coupling field according to one of the preceding claims, characterised thereby, that it displays input amplifiers (105, 106) and output amplifiers (107, 108) for the characteristic impedance matching and changing-over of symmetry (Fig. 6).

7. Coupling field according to one of the preceding claims, characterised thereby, that a coupling block displays four times four coupling points (Fig. 3).

8. Coupling field according to one of the preceding claims, characterised thereby, that it is part of a distributor coupling field, in which several mutually like coupling fields (120 to 123 in Fig. 7) are connected in parallel one with the other at the input side, whilst the outputs are led to terminals on a common output conductor plate (124).

**Revendications**

1. Panneau de couplage matriciel pour fréquences de signal dans la gamme des mégahertz, présentant les particularités suivantes :

a) il comprend des circuits de couplage intégrés chacun sur une pastille, prévus chacun pour plusieurs points de couplage, logés chacun dans un boîtier blindé (84, 89) et comportant deux interrupteurs à semiconducteurs par point de couplage,

b) les circuits de couplage intégrés sont disposés sur les zones d'intersection des lignes horizontales (31 à 38) et verticales (21 à 28) correspondantes d'une carte imprimée multicouche, qui comprend dans des plans différents des lignes horizontales et verticales de signal, entourées par des conducteurs de commande et/ou blindage et disposées chacune entre des plans de blindage métalliques (15, 16, 17),
et caractérisé en ce que

c) les lignes de signal (1, 2 sur la figure 2, 21 à 28, 31 à 38 sur la figure 3) sont réalisées sous forme de paires de microrubans symétriques par rapport à la terre et bouclées à leur deux extrémités par leur impédance caractéristique (Z sur la figure 2), deux conducteurs de commande ou d'alimentation (51, 52) reliés à la terre en haute fréquence étant disposés à l'intérieur d'un plan de conducteurs entre deux paires de conducteurs de signal (31, 32 et 33, 34) ;

d) les conducteurs de signal (39a, 39b) de chaque paire sont torsadés dans leur plan avec des pas différents, un détour (29) d'un conducteur au-dessus d'un autre plan de conducteurs étant prévu aux points d'intersection nécessaires (figure 3) ;

e) un nombre de lignes horizontales (31 à 38) ou verticales (21 à 28) adapté au nombre de points de couplage prévus par circuit intégré de couplage, fait partie d'un faisceau dont les conducteurs périphériques (60 à 64) sont des conducteurs d'alimentation des circuits intégrés de couplage, pour lesquels des condensateurs de blocage (91, 92) sont prévus sur des surfaces (90) sans conducteur de la carte imprimée, entre quatre circuits intégrés de couplage pour chacun (figure 3) ;

f) dans un circuit intégré de couplage, un amplificateur symétrique par rapport à la terre et commutable (T5, T6) est prévu par point de couplage comme interrupteur entre une ligne horizontale et une ligne verticale de signal, avec un circuit d'entrée en amont (T1, T2), présentant une impédance d'entrée élevée par rapport à l'impédance caractéristique (Z) de la ligne (1, 2) à signaux entrants, et avec un circuit de sortie en aval (T7, T8) avec une sortie (B, B') présentant une impédance élevée par rapport à la ligne à signaux sortants (figure 4) ;

g) l'amplificateur commutable (T5, T6) comprend, symétriquement par rapport à la terre, deux composants semiconducteurs actifs (T5, T6) commandables du domaine conducteurs sensiblement linéaire dans le domaine de blocage (composants de connexion) et symétriquement par rapport à la terre, deux composants semiconducteurs (T9, T10) de même type, géométriquement identique aux composants de connexion (T5, T6), bloqués en permanence (composants de compensation), dont l'émetteur est relié à l'émetteur d'un des composants de connexion (T5, T6), et dont le collecteur est relié au collecteur du second composant de connexion (T6, T5) pour compenser le surcouplage résiduel par les éléments de connexion bloqués (T5, T6, figure 5) ;

h) des éléments d'embrochage (83, figure 6) sont disposés à proximité du bord d'un circuit intégré de couplage pour des broches (86, figure 5) et des lignes de signal (87) aboutissant à la pastille (85) sont disposées dans le circuit intégré de couplage, entre des blindages (80, 81 en particulier) (figure 5).

2. Panneau de couplage selon revendication 1, caractérisé par l'emploi d'un connecteur (72) pour le détour (29) (figure 3).

3. Panneau de couplage selon une des revendications 1 ou 2, caractérisé en ce que le boîtier du circuit intégré de couplage (figure 5) est sensiblement carré et les directions des lignes horizontales et verticales de signal forment un angle avec les bords des faces du boîtier (figure 3).

4. Panneau de couplage selon une quelconque des revendications 1 à 3, caractérisé en ce qu'un circuit de commande permet de connecter simultanément plusieurs points de couplage situés sur une ligne de signal (30) reliée à une sortie du panneau de couplage.

5. Panneau de couplage selon une quelconque des revendications 1 à 4, caractérisé en ce que des signaux à fréquence porteuse différente (f1 ... f4) sont appliqués à diverses entrées du panneau de couplage, de façon que seules des fréquences porteuses différentes atteignent un circuit intégré de couplage.

6. Panneau de couplage selon une quelconque des revendications 1 à 5, caractérisé par des amplificateurs' d'entrée (105, 106) et de sortie (107, 108) pour l'adaptation de l'impédance caractéristique et la symétrisation (figure 6).

7. Panneau de couplage selon une quelconque des revendications 1 à 6, caractérisé en ce qu'un circuit intégré de couplage comporte 4 × 4 points de couplage (figure 3).

8. Panneau de couplage selon une quelconque des revendications 1 à 7, caractérisé en ce qu'il fait partie d'un panneau de couplage de distribution dans lequel plusieurs panneaux de couplage identiques (120 à 123 sur la figure 7) sont couplés en parallèle par leurs entrées, tandis que les sorties sont reliées à des douilles sur une carte imprimée de sortie commune (124).

# Fig. 1

# Fig. 2

# Fig. 3

Fig. 4

Fig. 5

86  84  87  88  85  88

80  81
83

96  15  95

16

94  17

Fig. 6

Fig. 6a

80
81
83

Fig. 6b

81  83  80

82

96

C

D

94

93

4

Fig. 7

Fig. 8